# EUROPEAN PATENT APPLICATION

(11) **EP 3 388 751 A1**
(43) Date of publication of application: **17.10.2018**
(21) Application number: 16872226.2
(22) Date of filing: 14.10.2016
(51) Int. Cl.: F24F 5/00, F24F 13/30, F24F 11/02

(54) **NATURAL COLD-SOURCE HEAT-DISSIPATION SYSTEM FOR VARIOUS DATA EQUIPMENT ROOMS**

(30) Priority: 10.12.2015 CN 201510909724; 10.12.2015 CN 201521026978 U
(71) Applicant: Guangdong Hi-1 New Materials Technology Research Institute Co., Ltd., Guangzhou, Guangdong 510635 (CN)
(72) Inventor: WANG, Wei, Guangzhou Guangdong 510635 (CN)
(74) Representative: Meyer, Thorsten
(86) International application number: PCT/CN2016/102111
(87) International publication number: WO 2017/097032

(57) **Abstract**

A natural cold-source heat-dissipation system for various data centers comprises an outdoor condenser (1), an indoor evaporator (2), and a thermal superconductive circulating device (3). An outlet of the outdoor condenser (1) is communicated with an inlet of the indoor evaporator (2) by means of the thermal superconductive circulating device (3), and an outlet of the indoor evaporator (2) is communicated with an inlet of the outdoor condenser (1) by means of a pipeline, so as to form a closed circulation system. The closed circulation system is filled with heat superconducting heat transfer working substance. The outdoor condenser (1) is an air-cooled condenser or a water-cooled condenser.

## Description

### FIELD OF THE INVENTION

The present invention relates to a natural cold-source heat-dissipation system for various data centers, which belongs to the field of heat dissipation technology for data centers.

### BACKGROUND OF THE INVENTION

With the rapid development of computer communication and the Internet, the development of the data centers has drawn much attention. The data centers commonly used in daily life and in production comprise control rooms of telecommunication base stations, various data processing centers, large computer/server rooms, cloud storage/cloud server centers, etc. The energy consumption of the above mentioned various data centers accounts for an increasing percentage of the social total energy consumption, and the energy consumption for cooling in the data centers accounts for over half of the total energy consumption of the data centers. Hence, the energy conservation and emission reduction become important industrial responsibilities and development tendencies of the construction of data centers. Conventional heat dissipation techniques for data centers are mainly achieved by air conditioners in the data centers. Under the conditions that the indoor heat is higher and the indoor and outdoor heat exchange conditions are poor, the energy efficiency ratio of the air conditioners will sharp decrease and meanwhile the power consumption will increase. In the case that the heat exchange condition is good, the service life of the air condition compressor will be reduced because of frequent starts and stops, the use of frequency conversion technology will increase the cost, and continuous operation will lead to a significant waste of electrical energy. All of these above will finally result in a higher PUE value of the data center. Furthermore, a bad geographical location of the data center will also bring difficulties to the installation of the air conditioners and to a safety and efficient use.

### SUMMARY OF THE INVENTION

The present invention aims to provide a natural cold-source heat-dissipation system for various data centers, which solves the problem that the service life and safety of the center cannot be ensured since the compressor has very high power consumption when data centers are cooled by the existing air conditioners, in particular that the efficiency is sharp decreased under poor heat dissipation conditions.

In order to achieve the above goal, the present invention provides a natural cold-source heat-dissipation system for various data centers, comprising an outdoor condenser, an indoor evaporator and a thermal superconductive circulating device, an outlet of the outdoor condenser is communicated with an inlet of the indoor evaporator by the thermal superconductive circulating device, an outlet of the indoor evaporator is communicated with an inlet of the outdoor condenser by a pipeline, to form a closed circulation system filled with heat superconducting heat transfer working substance. The outdoor condenser is an air-cooled condenser or water-cooled condenser.

The present invention has advantages as follows. The outdoor condenser of the present invention is an air-cooled condenser or water-cooled condenser. By using natural cold-source to dissipate heat, the use of compressors for cooling is greatly reduced. By using outdoor natural cold-source to dissipate heat, the use of the air conditioner inside the centers is greatly reduced and thus the power consumption of the centers is reduced. The arrangement of the indoor evaporator and the thermal superconductive circulating device, and the installation of the outdoor condenser, and the like, can be designed in various manners depending on the conditions such as geographical location and usage environment of the centers, thereby providing high adaptability. The entire structure is simple and compact, and has low manufacturing cost. The energy efficiency ratio of the system increases with the heat exchange amount, the PUE value of the data center is minimized, and the cost for heat-dissipation is reduced.

On the basis of the above technical solution, the present invention may be modified as follows.

Furthermore, in the natural cold-source heat-dissipation system for various data centers of the present invention, the outdoor condenser may be an air-cooled condenser. An atomization device is further installed or hung on one side of the air-cooled condenser, with a water fog nozzle facing towards the fins of the air-cooled condenser.

Furthermore, in the natural cold-source heat-dissipation system for various data centers of the present invention, the atomization device comprises an ultrasound atomizing generator, a water container, a fan, an atomizing shunt tube, and an air deflector for facilitating even distributed atomized water mist, wherein the ultrasound atomizing device is arranged inside the water container, the fan is installed on one side of the water container, the air deflector is installed at the upper part of the water container, and the atomizing shunt tube is mounted at the top of the water container and is communicated with the water container. Preferably, an automatic level float is further mounted inside the water container.

The above further technical solution of the present invention has advantages as follows. The bonding between the liquid-water molecules inside the water container is broke by the high frequency resonance generated by means of the ultrasound atomizing generator, water mist is produced and evenly sprayed to the fins of the condenser by means of the fan installed on one side of the water container and the atomizing shunt tube so as to adjust the air density and humidity, and the water mist with small molecules directly contacts with the fins of the condenser, such that the heat exchange efficiency of the condenser can be improved.

Furthermore, in the natural cold-source heat-dissipation system for various data centers of the present invention, the thermal superconductive circulating device comprises a circulating pipeline and a circulation adjusting device, the outlet of the indoor evaporator is communicated with the inlet of the outdoor condenser by a circulating pipeline, and the circulation adjusting device is mounted at the inlet of the indoor evaporator and/or mounted on the pipeline connected with the outlet of the outdoor condenser.

The above further technical solution of the present invention has advantages as follows. By means of the circulation adjusting device, the thermal superconductive heat exchange system can be controlled and accelerate heat exchange, thereby heat exchange capability of the circulation system can be improved.

Furthermore, in the natural cold-source heat-dissipation system for various data centers of the present invention, the circulation adjusting device may use a self-start type circulating control valve, that is, automatically adjust by heat exchange conditions of the thermal superconductive material in the circulating pipeline; or use an electrically-driven type circulating control valve, that is, electrically drive the circulation adjusting device to work by consuming very little electrical energy.

Furthermore, in the natural cold-source heat-dissipation system for various data centers of the present invention, the outdoor condenser may use various heat exchangers such as a fin tube heat exchanger, a shell and tube heat exchanger, a micro-channel heat exchanger.

The arrangement of the outdoor condenser and the indoor evaporator can be designed depending on actual working conditions of centers. The working performance of the thermal superconductive material can be controlled and adjusted by means of the circulation adjusting device, and the operation of the system will not be affected by gravity or the positions of the indoor machine and the outdoor machine and thus has high adaptability.

The heat superconducting heat transfer working substance used in the present invention has no phase change during the circulation of the system. After filling with the heat transfer working substance and performing debugging, performing vacuuming to remove non heat transfer working substance and then performing encapsulating. The start and stop of the system can be controlled and adjusted by means of the thermal superconductive circulation adjusting device, meanwhile the heat exchange efficiency of the working substance circulation can be improved, thereby achieving high-efficiency heat exchange and fast heat exchange. By means of the circulation adjusting device, the heat in the data center environment can be fully absorbed by the heat transfer working substance inside the indoor evaporator and quickly transferred to the outdoor condenser to dissipate heat and realize cooling by the natural cold-source. When the temperature difference between indoor and outdoor is 3-5°C, the natural cold-source heat-dissipation system starts to work, and the work efficiency of the system will not be affected by the mounting distance, the mounting positions and the mounting heights of the indoor machine and the outdoor machine.

The natural cold-source heat-dissipation system for various data centers of the present invention further comprises a controller.

The controller of the present invention is mainly used for controlling the operating states, such as the compatible state, monitor state and the start and stop, of the natural cold-source heat-dissipation system for various data centers and the air-conditioning system previously equipped in the centers. When the outdoor air temperature does not exceed 28°C, the heat exchange requirement of the centers can be satisfied by the natural cold-source heat-dissipation system. In bad conditions, for example in summer when both the ambient temperature and the humidity are high, the air-conditioning system previously equipped can be started and controlled by means of the controller, so as to assist the natural cold-source heat-dissipation system to dissipate the heat in the data centers.

Furthermore, in the natural cold-source heat-dissipation system for various data centers of the present invention, a plurality of indoor evaporators may be provided and connected in parallel, and finally communicates with a single high-power outdoor machine.

The above further technical solution of the present invention has advantages as follows. The natural cold-source can be fully used, and meanwhile the heat in the data center environment can be quickly transferred outdoors to dissipate heat.

### BRIEF DESCRIPTION OF THE DRAWINGS

Fig.1 is a schematic drawing illustrating a principle of a natural cold-source heat-dissipation system for various data centers according to the present invention;
Fig.2 is a schematic drawing of an atomization device of a natural cold-source heat-dissipation system for various data centers according to the present invention;

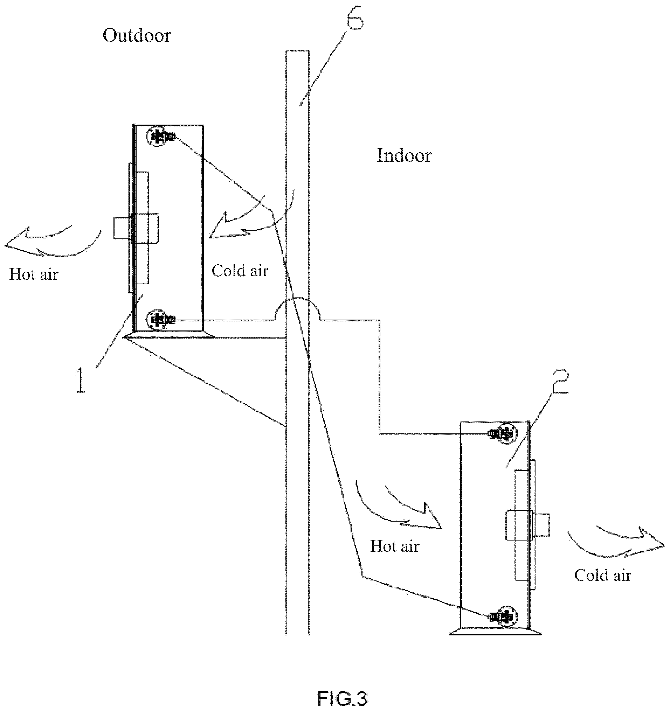

Fig.3 is a schematic drawing illustrating an installation example of a natural cold-source heat-dissipation system for various data centers according to the present invention;

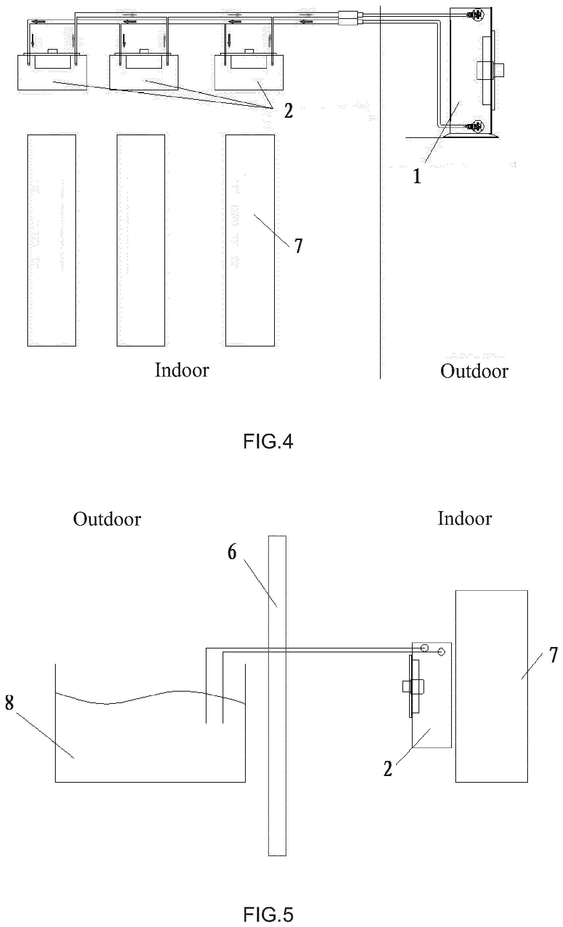

Fig.4 is a schematic drawing illustrating a different installation example of a natural cold-source heat-dissipation system for various data centers according to the present invention;
Fig.5 is a schematic drawing illustrating an installation example of a water cooled condenser used in a natural cold-source heat-dissipation system for various data centers according to the present invention.

In the drawings, the reference signs of the components are listed as follows.

1. outdoor condenser; 2. indoor evaporator; 3. thermal superconductive circulating device; 4. atomization device; 5. controller; 6. wall; 7. equipment cabinet; 8. water tank.

### DETAILED DESCRIPTION OF ILLUSTRATED EMBODIMENTS

In conjunction with the drawings, the principles and characteristics of the present invention have been described in the subsequent description. The embodiments described herein are to be regarded as illustrative rather than restrictive.

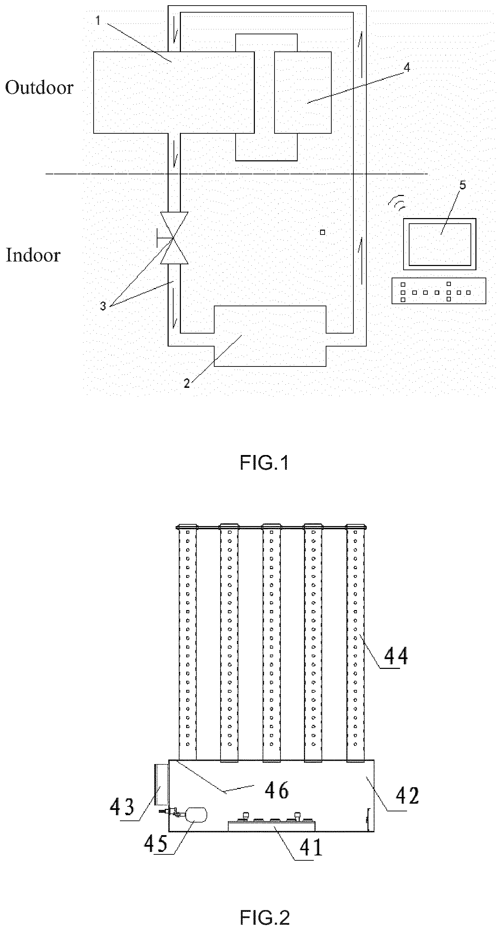

Referring to FIG.1, a natural cold-source heat-dissipation system for various data centers according to the present invention is provided, an equipment cabinet 7 is installed inside the data center, the natural cold-source heat-dissipation system comprises an outdoor condenser 1, an indoor evaporator 2, and a thermal superconductive circulating device 3, wherein an outlet of the outdoor condenser 1 is communicated with an inlet of the indoor evaporator 2 by a pipeline and the thermal superconductive circulating device, an outlet of the indoor evaporator 2 is communicated with an inlet of the outdoor condenser 1 by a circulating pipeline, so as to form a closed circulation system. The closed circulation system is filled with heat superconducting heat transfer working substance. The outdoor condenser for example may be an air-cooled condenser or a water-cooled condenser, etc. The water-cooled condenser comprises a water tank 8 for cooling the outdoor condenser, and according to the site and natural conditions outside the data center, a suitable heat-dissipating method can be selected and an appropriate arrangement of the outdoor machine can be designed.

In some particular embodiments of the natural cold-source heat-dissipation system for various data centers according to the present invention, the outdoor condenser may be an air-cooled condenser. An atomization device 4 is further installed or hung on one side of the air-cooled condenser, with a water fog nozzle facing towards the fins of the air-cooled condenser. In particular, the atomization device 4 comprises an ultrasound atomizing generator 41, a water container 42, a fan 43, atomizing shunt tubes 44, and an air deflector 46 for facilitating an even distributed atomized water mist. The ultrasound atomizing device is arranged inside the water container, the fan is installed on one side of the water container, the air deflector is installed at the upper part of the water container, and the atomizing shunt tubes are mounted at the top of the water container and are communicated with the water container. In a preferred embodiment, an automatic level float 45 is further installed inside the water container. When the water in the water container is atomized by means of the ultrasound atomizing generator, the water mist can be sprayed evenly to the fins of the condenser by means of the fan installed on one side of the water container and the atomizing shunt tubes, thereby improving the heat exchange efficiency of the condenser.

When the outdoor machine is under poor heat dissipation conditions, it is conceivable that the atomization device 4 may be arranged on one side of the outdoor condenser, so as to enhance heat exchange by changing air density. The secondary heat exchange mode, or others, are also conceivable.

In a specific implementing process, the thermal superconductive circulating adjusting device 3 is used for controlling and adjusting the start and stop and the heat exchange efficiency of the heat exchange circulation of the system, and it may be self-start type or electrically-driven type. The circulating adjusting device is usually mounted at the inlet of the indoor evaporator and/or mounted on the pipeline connected with the outlet of the outdoor condenser. By means of the circulating adjusting device, the heat exchange inside the indoor evaporator can be accelerated, and thus the heat exchange circulation of the system can be accelerated.

In some particular embodiments of the system according to the present invention, the thermal superconductive circulating adjusting device is omitted, and the system can be modified to provide a heat exchange circulation of a phase change gravity heat pipe by changing the heat superconducting material formulation. In this case, during the installation process, it must be ensured that the outdoor condenser lies at a higher position than the indoor evaporator all the time.

In some other particular embodiments, the outdoor condenser may use various heat exchangers such as fin tube heat exchanger, shell and tube heat exchanger, micro-channel heat exchanger, etc.

In some preferred embodiments of the natural cold-source heat-dissipation system for various data centers according to the present invention, a controller 5 is further provided. The controller of the present invention is mainly used for controlling the operating states, such as the compatible state, monitor state and the start and stop, of the natural cold-source heat-dissipation system for various data centers and the air-conditioning system previously equipped in the centers. When the outdoor air temperature does not exceed 28°C, the heat exchange requirement of the centers can be satisfied by the natural cold-source heat-dissipation system. In bad conditions, for example in summer when both the ambient temperature and the humidity are high, the air-conditioning system previously equipped can be started and controlled by means of the controller, so as to assist the natural cold-source heat-dissipation system to dissipate the heat in the data centers.

The heat superconducting heat transfer working substance used in the present invention has no phase change during the circulation of the system. After filling with the heat transfer working substance and performing debugging, performing vacuuming to remove non heat transfer working substance and then performing encapsulating. The start and stop of the system can be controlled and adjusted by means of the thermal superconductive circulating adjusting device, meanwhile the heat exchange efficiency of the working substance circulation can be improved, thereby achieving high-efficiency heat exchange and fast cooling. By means of the circulating adjusting device, the heat in the data center environment can be fully absorbed by the heat transfer working substance inside the indoor evaporator and quickly transferred to the outdoor condenser to dissipate heat and realize cooling by the natural cold-source. When the temperature difference between indoor and outdoor is 3-5°C, the natural cold-source heat-dissipation system starts to work, and the work efficiency of the system will not be affected by the mounting distance, the mounting positions and the mounting heights of the indoor machine and the outdoor machine.

The natural cold-source heat-dissipation system for various data centers according to the present invention works as follows. The hot air in the data center exchanges heat with the indoor evaporator; the heat superconducting heat transfer working substance inside the evaporator transfer the heat to the outdoor condenser quickly; the natural cold-source (for example the air and water, etc.) is used to realize adequate heat exchange outdoors with the outdoor condenser and absorb the heat of the heat transfer working substance inside the condenser to continuously cool it. In a specific working process, by means of the controller, the operating states of the temperature control system can be monitored, and the compatibility with the air-conditioning system previously equipped can be adjusted. The system has a simple structure and a stable operation.

Due to the special environment of the centers, lots of machines cannot be wetted with water, and the natural cold-source heat-dissipation system for various data centers according to the present invention may use non-liquid working substances (or the working substances being non-liquid after leakage), meanwhile most parts of the circulation pipeline of the thermal superconductive circulating adjusting device are arranged, as many as possible, on the outdoor side or arranged indoors in an interlayer under grounds, and meanwhile a value can be mounted at a node position to facilitate testing and maintenance. The indoor evaporator can be mounted as needed according to the indoor data center space. A plurality of indoor evaporator may be provided and installed in series or in parallel. If the heat-dissipation for particular position is required, each equipment cabinet may be installed with one indoor evaporator.

It should be understood that, as used herein, the terms which indicate orientation or position relationships, such as upper, lower, top, bottom, inside and outside, are described referring to the figures for convenience of description and better understanding of the present invention, but are not intended to mean or hint that the described device or unit must be arranged at specific position or operated by specific method to limit the invention in any way.

In the specification, unless otherwise explicitly stated, the terms such as "mount", "connect", "attach", "fix" should be interpreted broadly, for example, fix connection, attachable connection or integral connection, mechanical connection, direct connection or indirect connection by an intermediary. It will be apparent for those skilled in the art that the meanings of these terms in the present invention can be understood depending upon the situation. In the specification, the descriptions such as "one embodiment", "some embodiments", "example", "particular embodiment", "some examples" mean that the particular features, structures, materials or characteristics described in combination with the embodiments or examples are contained in at least one embodiment or example of the present invention. In the specification, illustrative descriptions of these terms are not necessary to aim at same embodiment or example. Furthermore, the described particular features, structures, materials or characteristics can be combined in one or more embodiments or examples in appropriate manners. Moreover, those skilled in the art may combine or modify different embodiments or examples or the features of different embodiments or examples described herein as long as they are not mutually contradictory.

All the above are merely the preferred embodiments of the present invention, but are not to limit the invention in any form. The present invention is intended to cover all changes, various modifications and equivalent arrangements included within the sprit and principle of the present invention.

## Claims

1. A natural cold-source heat-dissipation system for various data centers, **characterized in that**: it comprises an outdoor condenser (1), an indoor evaporator (2) and a thermal superconductive circulating device (3), wherein the outdoor condenser (1) has an outlet communicated with an inlet of the indoor evaporator (2) by the thermal superconductive circulating device (3), and the indoor evaporator (2) has an outlet communicated with an inlet of the outdoor condenser (1) by a communicating pipeline, so as to form a closed circulation system, wherein the closed circulation system is filled with heat superconducting heat transfer working substance, and the outdoor condenser (1) is an air-cooled condenser or a water-cooled condenser.

2. The natural cold-source heat-dissipation system for various data centers according to claim 1, **characterized in that**: the outdoor condenser is an air-cooled condenser (1), an atomization device (4) is further mounted on one side of the air-cooled condenser, and the atomization device (4) has a water fog nozzle facing towards a fin of the air-cooled condenser.

3. The natural cold-source heat-dissipation system for various data centers according to claim 2, **characterized in that**: the atomization device (4) comprises an ultrasound atomizing generator (41), a water container (42), a fan (43), an atomizing shunt tube (44), and an air deflector (46) for facilitating even distributed atomized water mist, wherein the ultrasound atomizing device (41) is arranged inside the water container (42), the fan (43) is installed on one side of the water container (42), the air deflector (46) is installed at the upper part of the water container (42), and the atomizing shunt tube (44) is mounted at the top of the water container (42) and is communicated with the water container (42).

4. The natural cold-source heat-dissipation system for various data centers according to claim 1, **characterized in that**: the thermal superconductive circulating device (3) comprises a circulating pipeline and a circulation adjusting device, the outlet of the indoor evaporator (2) is communicated with the inlet of the outdoor condenser (1) by the circulating pipeline, and the circulation adjusting device is mounted at the inlet of the indoor evaporator (2) and/or mounted on a pipeline connected with the outlet of the outdoor condenser (1).

5. The natural cold-source heat-dissipation system for various data centers according to claim 4, **characterized in that**: the circulation adjusting device uses a self-start type circulating control valve or an electrically-driven type circulating control valve.

6. The natural cold-source heat-dissipation system for various data centers according to anyone of claims 1-5, **characterized in that**: the outdoor condenser (1) use a fin tube heat exchanger, a shell and tube heat exchanger, or a micro-channel heat exchanger.

7. The natural cold-source heat-dissipation system for various data centers according to anyone of claims 1-5, **characterized in that**: a controller (5) is further provided.

8. The natural cold-source heat-dissipation system for various data centers according to anyone of claims 1-5, **characterized in that**: a plurality of indoor evaporators (2) are provided in parallel.
